**Europäisches Patentamt**

**European Patent Office**

**Office européen des brevets**

(19)

(11) Veröffentlichungsnummer: **0 213 634**
**B1**

(12) **EUROPÄISCHE PATENTSCHRIFT**

(45) Veröffentlichungstag der Patentschrift:
07.02.90

(51) Int. Cl.⁴: **G05F 1/56,** H03F 3/30,
H03F 3/347

(21) Anmeldenummer: **86112157.2**

(22) Anmeldetag: **02.09.86**

(54) **Gesteuerte Stromquellenanordnung.**

(30) Priorität: **02.09.85 DE 3531323**

(43) Veröffentlichungstag der Anmeldung:
**11.03.87 Patentblatt 87/11**

(45) Bekanntmachung des Hinweises auf die Patenterteilung:
**07.02.90 Patentblatt 90/6**

(84) Benannte Vertragsstaaten:
**AT BE DE FR GB IT NL SE**

(56) Entgegenhaltungen:
**DE-A- 2 508 801**
**US-A- 4 342 006**
**US-A- 4 481 481**

**PROCEEDINGS OF THE IEEE, Band 69, Nr. 11,**
**November 1981, Seiten 1514,1515, IEEE, New York, US;**
**B. WILSON: "A low-distortion bipolar feedback current**
**amplifier technique"**
**PATENTS ABSTRACTS OF JAPAN, Band 10,**
**Nr. 152 (P-462)[2208], 3. Juni 1986; & JP-A-61 5321**

(73) Patentinhaber: **Siemens Aktiengesellschaft,**
**Wittelsbacherplatz 2, D-8000 München 2(DE)**

(72) Erfinder: **Koch, Rudolf, Dr., Goerdelerstrasse 18,**
**D-8025 Unterhaching(DE)**
Erfinder: **Schmid, Eberhard, Dr., Heppstrasse 113,**
**D-7410 Reutlingen(DE)**

## Beschreibung

Die Erfindung betrifft eine gesteuerte Stromquellenanordnung, wie sie im Oberbegriff des Anspruchs 1 beschrieben ist.

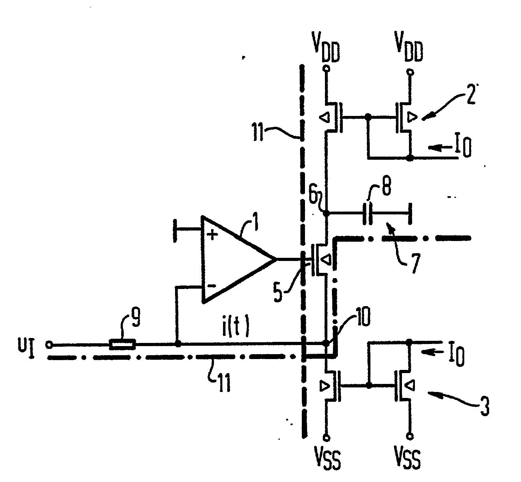

Von G.B. Clayton ist in der Veröffentlichung "Operational Amplifiers", Second Edition, 1983, Fig. 4.20, eine Stromquellenanordnung offenbart, die einen rückgekoppelten Operationsverstärker aufweist. Über den Rückkopplungszweig wird eine Spannung an den Eingang gelegt, die von einem als Spannungs/Stromwandler dienenden Widerstand abgeleitet ist, und welche mittelbar den einer Last zugeführten Strom mißt. Der Operationsverstärker steuert über einen Transistor den Last-Strom.

Diese Anordnung hat den Nachteil, daß nur positive Eingangsspannungen angelegt werden können. Ferner ist ausgangsseitig nur eine Stromrichtung möglich. Damit ist diese Anordnung für die Verarbeitung von Wechselsignalen ungeeignet.

Der Erfindung lag daher die Aufgabe zugrunde, eine Stromquellenanordnung der eingangs genannten Art anzugeben, mit welcher Ausgangsströme unterschiedlichen Vorzeichens erzeugt werden können.

Diese Aufgabe wird gemäß dem kennzeichnenden Teil des Anspruchs 1 gelöst.

Die Erfindung beruht darauf, daß dem in der Regelstrecke fließenden Signalstrom ein erster Gleichstrom überlagert wird, und daß von dem in die Last fließenden Strom wiederum ein zweiter Gleichstrom, vorzugsweise der selben Größe, subtrahiert wird.

Die Erfindung hat den Vorteil, daß die Anordnung durch die Verwendung der Stromquellen sehr gut für die Realisierung in einer integrierten Schaltung geeignet ist. Sie hat ferner den Vorteil, daß auf einfache Weise Integratorschaltungen realisierbar sind, wenn eine kapazitive Last vorhanden ist. Eine derartige Integratorschaltung zeichnet sich dadurch aus, daß sie gegenüber den bisher bekannten RC- und SC-Integratoren für höhere Frequenzbereiche verwendet werden kann.

Vorteilhafte Weiterbildungen der Erfindung ergeben sich aus den Unteransprüchen.

Im folgenden wird die Erfindung anhand eines in einer Figur dargestellten Ausführungsbeispieles weiterbeschrieben.

Wie die Figur zeigt, besteht die Stromquellenanordnung aus einem Operationsverstärker 1, aus einem vom Operationsverstärker 1 angesteuerten Transistor 5 und aus einer ersten und zweiten Stromquelle 2, 3. Am Ausgang der Anordnung liegt an einem Knotenpunkt 6 eine Last 7, die in dem wiedergegebenen Bespiel aus einem Kondensator 8 besteht. Zusammen mit einem eingangsseitigen Widerstand 9 stellt diese Beschaltung einen Integrator dar. Am Kondensator ist demnach eine Spannung

$$U_c = \frac{1}{RC} \int U_I \, dt$$

abgreifbar.

Über den rückgekoppelten Operationsverstärker 1 wird aus einem Eingangssignal $u_I$ ein Signalstrom $i(t) = U_I/R$ erzeugt. Dies erfolgt durch eine Ansteuerung eines Transistors 5 über den Operationsverstärker 1, der in einen Rückkopplungszweig über einen Knoten 10 auf den "-"-Eingang des Operationsverstärkers 1 zurückfließt und am Widerstand 9 ein Gegenkopplungssignal erzeugt. Am "+"-Eingang des Operationsverstärkers liegt ein Bezugspotential.

Am Knoten 10 wird zu diesem Signalstrom $i(t)$ ein erster Gleichstrom $I_0$ aus einer ersten Stromquelle 3 addiert, so daß durch den Transistor 5 die Summe des Signalstromes $i(t)$ und des überlagerten ersten Gleichstroms $I_0$ fließt. An einem weiteren Knoten 6 wird durch eine zweite Stromquelle 2 ein zweiter Gleichstrom $I_0$ von den beiden anderen Strömen subtrahiert. Am Knoten 6 liegt die Verbindung zur Last 7, so daß in die Last nur der Signalstrom $i(t)$ fließt, wenn der erste und zweite Gleichstrom gleich groß sind bzw. ansonsten zusätzlich die Differenz aus dem ersten und zweiten Gleichstrom.

Die erste und die zweite Stromquelle sind als an sich bekannte Stromspiegelspannungen ausgebildet, so daß sie hier nicht im einzelnen beschrieben sind.

Zur Veranschaulichung der Funktion ist der Signalstrompfad durch eine strichpunktierte Linie 11 gekennzeichnet. Der Gleichstrompfad, der zwischen zwei Betriebspotentialen $V_{DD}$ und $V_{SS}$ liegt, ist durch eine gestrichelte Linie 12 gekennzeichnet. Somit ist ohne weiteres aus der Figur zu entnehmen, daß lediglich auf einem gemeinsamen Strompfad zwischen dem Knoten 10 und dem weiteren Knoten 6 der aus dem Signalstrom $i(t)$ und dem ersten Gleichstrom $I_0$ zusammengesetzte Strom geführt wird.

## Patentansprüche

1. Gesteuerte Stromquellenanordnung mit

a) einer Eingangsklemme für ein Eingangssignal $U_I$,

b) einem Spannungs-Strom-Wandler, der einen Widerstand (9) und einen Transistor (5) aufweist und der aus dem Eingangssignal $U_I$ einen Signalstrom $i(t)$ erzeugt,

c) einer Ausgangsklemme (6) zur Speisung einer Last (7) mit einem Ausgangsstrom, gekennzeichnet durch:

d) eine erste Stromquelle (3) zur Abgabe eines ersten Gleichstromes,

e) eine zweite, parallel zur Last (7) liegende Stromquelle (2) zur Abgabe eines zweiten Gleichstromes,

f) Mittel zum Addieren von Signalstrom $i(t)$ und erstem Gleichstrom,

g) Mittel zum Subtrahieren des zweiten Gleichstromes von der Summe aus dem Signalstrom und erstem Gleichstrom, wobei der Ausgangsstrom dem Signalstrom und der Differenz aus dem ersten und zweiten Gleichstrom entspricht.

2. Stromquellenanordnung nach Anspruch 1, **dadurch gekennzeichnet**, daß der erste und zweite Gleichstrom gleich groß sind.

3. Stromquellenanordnung nach einem der Ansprüche 1 oder 2, **dadurch gekennzeichnet**, daß die erste und zweite Stromquelle (2, 3) durch eine Stromspiegelanordnung realisiert sind.

4. Stromquellenanordnung nach Anspruch 3, **dadurch gekennzeichnet**, daß die erste und zweite Stromquelle (2, 3) durch eine Kaskode realisiert sind.

5. Stromquellenanordnung nach Anspruch 3, **dadurch gekennzeichnet**, daß die erste und zweite Stromquelle (2, 3) als Wilson-Stromquelle ausgebildet sind.

6. Stromquellenanordnung nach einem der vorhergehenden Ansprüche, **dadurch gekennzeichnet**, daß die Last (7) aus einer Kondensatoranordnung besteht.

7. Stromquellenanordnung nach einem der vorhergehenden Ansprüche, **gekennzeichnet** durch einen nichtlinearen Strom/Spannungswandler.

## Claims

1. Controlled current source arrangement having
a) an input terminal for an input signal $U_I$,
b) a voltage-converter which has a resistor (9) and a transistor (5) and which produces a signal current i(t) from the input signal $U_I$,
c) an output terminal (6) supplying a load (7) with an output current, characterized by:
d) a first current source (3) for supplying a first DC current,
e) a second current source (2), which is parallel to the load (7), for supplying a second DC current,
f) means for summing the signal current i(t) and the first DC current,
g) means for substracting the second DC current from the sum of the signal current and first DC current, the output current corresponding to the signal current and the difference between the first and second DC current.

2. Current source arrangement according to Claim 1, characterized in that the first and second DC currents are equally large.

3. Current source arrangement according to Claims 1 or 2, characterized in that the first and second current sources (2, 3) are realized by a current mirror arrangement.

4. Current source arrangement according to Claim 3, characterized in that the first and second current sources (2, 3) are realized by a castcode.

5. Current source arrangement according to Claim 3, characterized in that the first and second current sources (2, 3) are in the form of a Wilson current source.

6. Current source arrangement according to one of the preceding claims, characterized in that the load (7) consists of a capacitor arrangement.

7. Current source arrangement according to one of the preceding claims, characterized by a non-linear current-voltage converter.

## Revendications

1. Dispositif à sources de courant, commandé comportant

a) une borne d'entrée pour un signal d'entrée $U_I$,
b) un convertisseur tension-courant, qui comporte une résistance (9) et un transistor (5) et produit, à partir du signal d'entrée $U_I$, un courant de signal i(t),
c) une borne de sortie (6) servant à alimenter une charge (7) avec un courant de sortie, caractérisé par
d) une première source de courant (3) servant à délivrer un premier courant continu,
e) une seconde source de courant (2) parallèle à la charge (7) et servant à délivrer un second courant continu,
f) des moyens pour additionner le courant de signal i(t) et le premier courant continu,
g) des moyens pour soustraire le second courant continu de la somme du premier courant de signal et du premier courant continu, le courant de sortie correspondant au courant de signal et à la différence entre le premier courant continu et le second courant continu.

2. Dispositif à sources de courant suivant la revendication 1, caractérisé par le fait que les premier et second courants continus sont égaux.

3. Dispositif à sources de courant suivant l'une des revendications 1 ou 2, caractérisé par le fait que les première et seconde sources de courant (2, 3) sont constituées par un dispositif formant miroir de courant.

4. Dispositif à sources de courant suivant la revendication 3, caractérisé par le fait que les première et seconde sources de courant (2, 3) sont formées par un montage cascode.

5. Dispositif à sources de courant suivant la revendication 3, caractérisé par le fait que les première et seconde sources de courant (2, 3) sont réalisées sous la forme d'une source de courant de Wilson.

6. Dispositif à sources de courant suivant l'une des revendications précédentes, caractérisé par le fait que la charge (7) est constituée par un condensateur.

7. Dispositif à sources de courant suivant l'une des revendications précédentes, caractérisé par un convertisseur courant/tension non linéaire.